(19) Europäisches Patentamt
European Patent Office
Office européen des brevets

(11) **EP 4 206 123 A1**

(12) **EUROPEAN PATENT APPLICATION**
published in accordance with Art. 153(4) EPC

(43) Date of publication:
**05.07.2023 Bulletin 2023/27**

(21) Application number: **21875542.9**

(22) Date of filing: **27.09.2021**

(51) International Patent Classification (IPC):
**C01B 21/082** (2006.01)     **C01B 21/064** (2006.01)
**C04B 35/583** (2006.01)     **C04B 41/82** (2006.01)

(52) Cooperative Patent Classification (CPC):
**C01B 21/064; C01B 21/082; C04B 35/583;
C04B 41/82**

(86) International application number:
**PCT/JP2021/035435**

(87) International publication number:
**WO 2022/071240 (07.04.2022 Gazette 2022/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.09.2020  JP 2020163436**

(71) Applicant: **Denka Company Limited
Tokyo 103-8338 (JP)**

(72) Inventors:
• **IKARASHI, Koki
Tokyo 103-8338 (JP)**
• **SUZUKI, Nobuya
Tokyo 103-8338 (JP)**
• **NISHIMURA, Koji
Tokyo 103-8338 (JP)**

(74) Representative: **Hoffmann Eitle
Patent- und Rechtsanwälte PartmbB
Arabellastraße 30
81925 München (DE)**

(54) **BORON CARBONITRIDE POWDER AND METHOD FOR PRODUCING SAME, POWDER COMPOSITION, BORON NITRIDE SINTERED COMPACT AND METHOD FOR PRODUCING SAME, AND COMPLEX AND METHOD FOR PRODUCING SAME**

(57)     Provided is a boron nitride sintered body in which an average number of lump particles having a particle size of 30 $\mu$m or more formed by aggregation of primary particles of boron nitride is 3 or less in a cross-sectional image including 100 or more particles observed at a magnification of 500 times with a scanning electron microscope. A method of manufacturing a boron nitride sintered body includes a nitriding step of sintering a raw material powder containing boron carbide in a nitrogen-containing atmosphere to obtain a fired product containing boron carbonitride, a pulverizing step of pulverizing the fired product to obtain a boron carbonitride powder having a specific surface area of 12 m$^2$/g or more, and a firing step of molding and heating a blend containing the boron carbonitride powder and a sintering aid to obtain a boron nitride sintered body.

*Fig.3*

EP 4 206 123 A1

**Description**

**Technical Field**

The present disclosure relates to a boron carbonitride powder and a method for producing the same, a powder composition, a boron nitride sintered body and a method for producing the same, and a composite body and a method for producing the same.

**Background Art**

In components such as power devices, transistors, thyristors, and CPUs efficiently dissipation of heat generated during use thereof is required. In response to such demands, attempts have been made to increase thermal conductivity of an insulating layer of a printed wiring board on which an electronic component is mounted, and to attach the electronic component or the printed wiring board to a heat sink via thermal interface materials having electrical insulating properties. Ceramic is used as the insulating layer and the thermal interface material.

Boron nitride, which is a type of ceramic, has excellent lubricity, thermal conductivity, and insulating properties. For this reason, it has been studied to use boron nitride or a composite material of boron nitride and another material as the insulating layer and the thermal interface materials. For example, Patent Literature 1 proposes a technique in which a boron nitride molded body is combined with a resin and the degree of orientation and graphitization index of the boron nitride are set within predetermined ranges to reduce anisotropy of thermal conductivity while achieving excellent thermal conductivity.

**Citation List**

**Patent Literature**

Patent Literature 1: Japanese Unexamined Patent Publication No. 2014-162697

**Summary of Invention**

**Technical Problem**

With the recent high integration of circuits in devices such as semiconductor devices, there is a demand for a heat dissipation member having heat dissipation characteristics higher than those of conventional members. Accordingly, the present disclosure provides a boron nitride sintered body having sufficiently high thermal conductivity and a method for manufacturing the same. Furthermore, the present disclosure provides a composite body having sufficiently high thermal conductivity and a method for manufacturing the same. Furthermore, the present disclosure provides a boron carbonitride powder which enables manufacturing such a boron nitride sintered body and composite body, a method for manufacturing the same, and a powder composition.

**Solution to Problem**

According to an aspect of the present disclosure, there is provided a boron carbonitride powder comprising a lump particle of boron carbonitride having micropores, in which a specific surface area of the boron carbonitride powder is 12 $m^2$/g or more. Since the boron carbonitride powder has a small lump particle size, it can be used as a sintering raw material to manufacture a sufficiently densified boron nitride sintered body. Such a boron nitride sintered body has high thermal conductivity.

Primary particles of the boron carbonitride may be exposed at an outer edge of the lump particle contained in the boron carbonitride powder. When the boron carbonitride powder containing the lump particle and a sintering aid are mixed and sintered, grain growth of the primary particles is promoted by the sintering aid. As a result, densification of the lump particle is promoted, and a more densified boron nitride sintered body can be manufactured. Such a boron nitride sintered body has a higher thermal conductivity.

According to an aspect of the present disclosure, there is provided a powder composition comprising an lump particle of boron carbonitride having micropores and a sintering aid, in which a specific surface area of the powder composition is 12 $m^2$/g or more. Since such a powder composition has a large specific surface area, it can be used as a sintering raw material to manufacture a sufficiently densified boron nitride sintered body. Such a boron nitride sintered body has high thermal conductivity.

According to an aspect of the present disclosure, there is provided a boron nitride sintered body comprising primary particles of boron nitride, in which, in a cross-sectional image including 100 or more particles observed at a magnification of 500 times with a scanning electron microscope, an average number of lump particles having a particle size of 30 $\mu$m or more formed by aggregation of the primary particles is 3 or less. Such a boron nitride sintered body has a sufficiently high thermal conductivity since lump particles having a large particle size are sufficiently reduced.

An orientation index of the boron nitride sintered body may be 10 or less. Accordingly, anisotropy of thermal conductivity can be sufficiently reduced. The thermal conductivity of the boron nitride sintered body may be 26 W/(m· K) or more, or may be 35 W/(m· K) or more.

According to an aspect of the present disclosure, there is provided a method for manufacturing a boron carbonitride powder, the method including: a nitriding step of firing a raw material powder containing boron carbide in a nitrogen-containing atmosphere to obtain a fired product containing boron carbonitride; and a pulverizing step of pulverizing the fired product to obtain a boron carbonitride powder having a specific surface area of 12 m$^2$/g or more. The manufacturing method includes a pulverizing step of pulverizing a fired product containing boron carbonitride obtained by nitriding boron carbide to obtain a boron carbonitride powder having a specific surface area of a predetermined value or more. In this pulverizing step, the outer shell of the lump particle is pulverized to micronize the lump particle. The micronized boron carbonitride powder is sufficiently densified by firing. Therefore, when the boron carbonitride powder obtained by the above-described manufacturing method is used for manufacturing a boron nitride sintered body, a boron nitride sintered body having sufficiently high thermal conductivity can be manufactured.

According to an aspect of the present disclosure, there is provided a method for manufacturing a boron nitride sintered body, the method including: a nitriding step of firing a raw material powder containing boron carbide in a nitrogen-containing atmosphere to obtain a fired product containing boron carbonitride; a pulverizing step of pulverizing the fired product to obtain a boron carbonitride powder having a specific surface area of 12 m$^2$/g or more; and a firing step of molding and heating a blend containing the boron carbonitride powder and a sintering aid to obtain the boron nitride sintered body. In the pulverizing step, the outer shell of the lump particle of boron carbonitride contained in the fired product is pulverized to micronize the lump particle. The boron carbonitride powder obtained by micronizing smoothly produces boron nitride and is sufficiently densified when fired. Therefore, densification of boron nitride in the firing step is promoted, and a boron nitride sintered body having sufficiently high thermal conductivity can be manufactured.

In one aspect, the present disclosure provides a method for manufacturing a boron nitride sintered body, the method including: a nitriding step of firing a raw material powder containing boron carbide in a nitrogen-containing atmosphere to obtain a fired product containing boron carbonitride; a pulverizing step of mixing and pulverizing the fired product and a sintering aid to obtain a powder composition containing boron carbonitride powder and the sintering aid and having a specific surface area of 12 m$^2$/g or more; and a firing step of molding and heating the powder composition to obtain the boron nitride sintered body. Also, in the pulverizing step, the outer shell of the lump particle of boron carbonitride contained in the fired product is pulverized to micronize the lump particle. The powder composition containing a boron carbonitride powder and a sintering aid, which is obtained by micronizing, smoothly produces boron nitride and is sufficiently densified when fired. Therefore, densification of boron nitride in the firing step is promoted, and a boron nitride sintered body having sufficiently high thermal conductivity can be manufactured.

The pulverizing step may be performed using a pulverizer. This makes it possible to efficiently produce a sufficiently fine boron carbonitride powder. By using such a boron nitride powder, a boron nitride sintered body in which densification is further promoted can be produced with high production efficiency.

The boron carbonitride powder may contain lump particles of boron carbonitride having micropores, and primary particles of boron carbonitride may be exposed at an outer edge of the lump particles. When the primary particles of boron carbonitride are exposed from the lump particles, it is considered that the formation reaction of boron nitride and the grain growth of the primary particles are promoted by the action of the sintering aid. Accordingly, a boron nitride sintered body having a higher thermal conductivity may be manufactured.

In one aspect, the present disclosure provides a composite body including any one of the boron nitride sintered bodies described above and a resin filled in pores of the boron nitride sintered body. Since such a composite body includes the above-described boron nitride sintered body, it has sufficiently high thermal conductivity. Therefore, it can be suitably used as, for example, a heat dissipation member.

In one aspect, the present disclosure provides a method for manufacturing a composite body, the method including an impregnating step of impregnating pores of the boron nitride sintered body obtained by any one of the above-described manufacturing methods with a resin composition, the composite body having the boron nitride sintered body and a resin filled in at least some of the pores of the boron nitride sintered body. Since such a composite body includes the above-described boron nitride sintered body, it has sufficiently high thermal conductivity. Therefore, it can be suitably used as, for example, a heat dissipation member.

**Advantageous Effects of Invention**

According to the present disclosure, it is possible to provide a boron nitride sintered body having sufficiently high thermal conductivity and a method for manufacturing the same. In addition, a composite body having sufficiently high thermal conductivity and a method of manufacturing the same may be provided. In addition, it is possible to provide a boron carbonitride powder capable of manufacturing such a boron nitride sintered body, a method for manufacturing the same, and a powder composition.

**Brief Description of Drawings**

[FIG. 1] FIG. 1 is an SEM photograph showing an example of lump particles contained in a boron carbonitride powder according to an embodiment.
[FIG. 2] FIG. 2 is an SEM photograph showing a comparative example of lump particles of boron carbonitride.
[FIG. 3] FIG. 3 is a diagram schematically showing a cross section of a boron nitride sintered body according to an embodiment.
[FIG. 4] FIG. 4 is an SEM photograph showing an example of a cross-section of a boron nitride sintered body according to an embodiment.
[FIG. 5] FIG. 5 is an SEM photograph showing a comparative example of a cross section of a boron nitride sintered body.
[FIG. 6] FIG. 6 is an SEM photograph of the fired product before pulverization in Example 1.
[FIG. 7] FIG. 7 is an SEM photograph of the boron carbonitride powder after pulverization in Example 1.

**Description of Embodiments**

Hereinafter, embodiments of the present disclosure will be described with reference to the drawings as necessary. However, the following embodiments are examples for describing the present disclosure, and are not intended to limit the present disclosure to the following contents.

A boron carbonitride powder according to an embodiment contains a lump particle of boron carbonitride having micropores. The boron carbonitride powder contains boron carbonitride as a main component, and may contain an accessory component other than boron carbonitride. Examples of the accessory component include boron carbide, carbon, diboron trioxide, and boric acid. The content ratio of boron carbonitride in the boron carbonitride powder may be 60% by mass or more, 70% by mass or more, 80% by mass or more, or 90% by mass or more. The content ratio of boron carbonitride can be obtained based on, for example, a measurement value of an oxygen/nitrogen analyzer.

The boron carbonitride powder has a specific surface area of 12 $m^2$/g or more. This specific surface area is measured by the BET single point method. The specific surface area may be 13 $m^2$/g or more, 14 $m^2$/g or more, or 15 $m^2$/g or more from the viewpoint of promoting generation and densification of boron nitride when used as a raw material to be sintered. In addition, from the viewpoint of sufficiently increasing the thermal conductivity when the boron nitride sintered body is formed, the specific surface area of the boron carbonitride powder may be 70 $m^2$/g or less, or may be 60 $m^2$/g or less. An example of the specific surface area of the boron carbonitride powder may be 12 to 70 $m^2$/g.

The boron carbonitride powder may contain a plurality of lump particles. In this case, the maximum value of the particle size may be 50 $\mu$m or less, 40 $\mu$m or less, or 35 $\mu$m or less. The particle size is measured by the following procedure. Two dimensional images of lump particles are taken by a scanning electron microscope (SEM). Images are photographed in 20 visual fields reflecting positions different from each other, and the particle size of each lump particle included in each image is measured. Particle size is measured as the distance between two points on the outer edge selected to have the largest spacing in one lump particle.

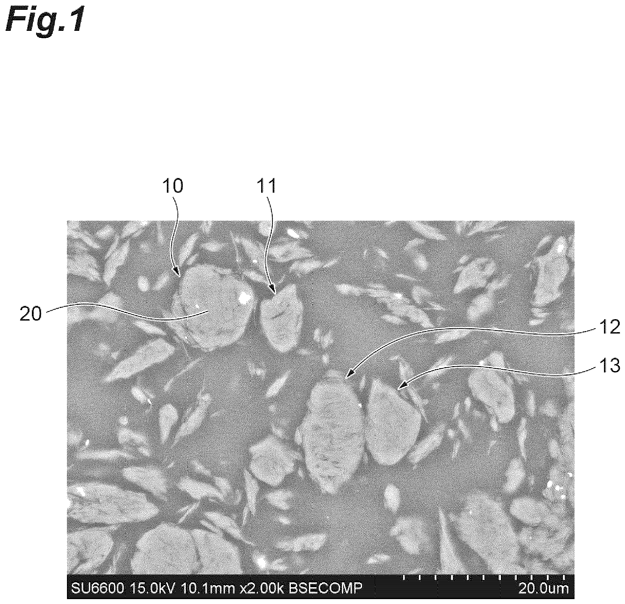

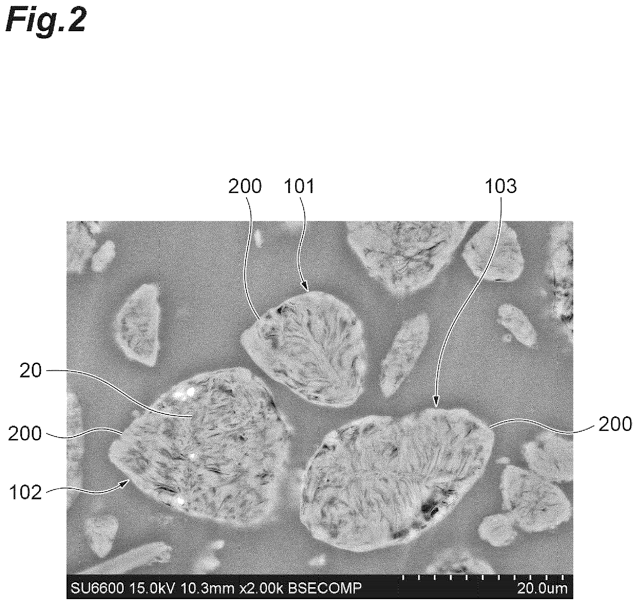

FIG. 1 is an SEM photograph of a cross section showing an example of lump particles of boron carbonitride contained in the boron carbonitride powder of the present embodiment. FIG. 2 is an SEM photograph of a cross section showing a comparative example of lump particles of boron carbonitride. Lump particles 10, 11, 12, and 13 shown in FIG. 1 contain micropores, and further contains a plurality of primary particles 20 of boron carbonitride. The lump particles 10, 11, 12, and 13 do not have an outer shell part forming its outline, and primary particles 20 are exposed at the outer edge of the lump particle. Lump particles 101, 102, and 103 shown in FIG. 2 include a plurality of primary particles 20 of boron carbonitride and an outer shell part 200 surrounding the plurality of primary particles 20. The outer shell part 200 forms the contour of lump particles 101, 102, and 103 over the entire circumference of the lump particles 101, 102, and 103.

Since the boron carbonitride powder containing the lump particles 10, 11, 12, and 13 as shown in FIG. 1 does not have the outer shell part 200, when the boron carbonitride powder is used as a raw material for sintering a boron nitride sintered body, the formation and densification of boron nitride proceed smoothly. The reason for this is considered to be that since the primary particles 20 are exposed from the lump particles 10, 11, and 12, when a sintering aid is blended, the sintering aid and the primary particles 20 come into contact with each other to promote the generation of boron nitride and the grain growth. The boron nitride sintered body obtained in this manner is sufficiently densified and has sufficiently high thermal conductivity. Further, the anisotropy of the thermal conductivity is reduced, and the versatility as a member can be improved. Thus, the boron carbonitride powder is suitable for the production of boron nitride sintered bodies. However, the use of the boron carbonitride powder is not limited to the production of boron nitride sintered bodies.

The powder composition according to an embodiment contains the lump particle and a sintering aid. The content of boron carbonitride in the powder composition may be 70% by mass or more or 80% by mass or more, from the viewpoint of obtaining a boron nitride sintered body having few impurities. The content of the sintering aid in the powder composition may be 5% by mass or more, or may be 10% by mass or more from the viewpoint of promoting sintering. The sintering aid is a component that promotes a reaction of generating boron nitride from boron carbonitride and densification of boron nitride when the powder composition is heated. The sintering aid may contain a boron compound having oxygen as a constituent element and a calcium compound. Examples of the boron compound include boric acid, boron oxide, borax, and diboron trioxide. Examples of the calcium compound include calcium carbonate and calcium oxide. The sintering aid may contain a component other than the boron compound and calcium carbonate. Examples of such a component include alkali metal carbonates such as lithium carbonate and sodium carbonate.

The specific surface area of the powder composition is 12 $m^2/g$ or more. This specific surface area is measured by the BET single point method. The specific surface area may be 13 $m^2/g$ or more, 14 $m^2/g$ or more, or 15 $m^2/g$ or more from the viewpoint of promoting generation and densification of boron nitride when used as a raw material to be sintered. From the viewpoint of sufficiently increasing the thermal conductivity when the boron nitride sintered body is used, the specific surface area of the powder composition may be 80 $m^2/g$ or less, 70 $m^2/g$ or less, or 60 $m^2/g$ or less. An example of the specific surface area of the powder composition may be 12 to 80 $m^2/g$.

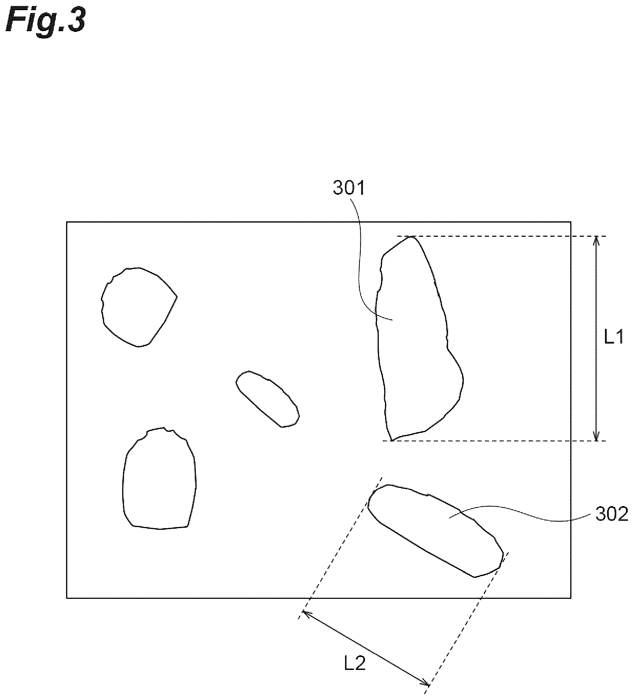

In the boron nitride sintered body according to an embodiment, an average number of lump particles having a particle size of 30 $\mu$m or more, which are formed by aggregation of primary particles of boron nitride, is 3 or less in a cross-sectional image including 100 or more particles, which is observed at a magnification of 500 times using a scanning electron microscope (SEM). The particle size of lump particles included in a cross-sectional image (SEM image) is measured as distances L1, L2, or the like between two points on outer edges of lump particles 301 and 302 selected to have the largest interval as illustrated in FIG. 3. Although 100 particles are not shown in FIG. 3 for ease of viewing, a cross-sectional image including 100 or more particles is used for actual measurement.

Cross-sectional observation with a scanning electron microscope (SEM) is performed at five or more different fields of view. Then, an average of the number of lump particles having a particle size of 30 $\mu$m or more observed in each visual field is obtained. This makes it possible to sufficiently reduce variations caused by selection of the field of view.

The 100 particles can be counted without any particular limitation as long as they are discriminated in the image. If the primary particles cannot be discriminated in one lump particle, the number of particles is one. On the other hand, when 10 primary particles are aggregated to form one lump particle, the number of particles is counted as 10 as the number of primary particles. The use of an image including 100 or more lump particles is intended to exclude a case where only lump particles having a large particle size are arbitrarily captured and the number of lump particles having a particle size of 30 $\mu$m or more is counted more than the actual number.

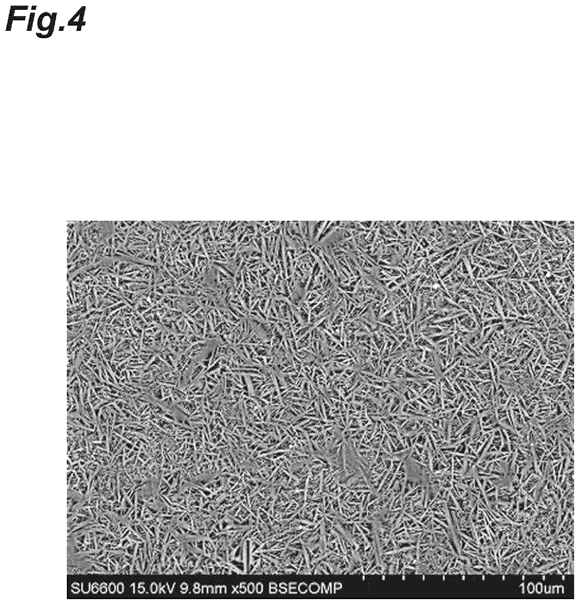

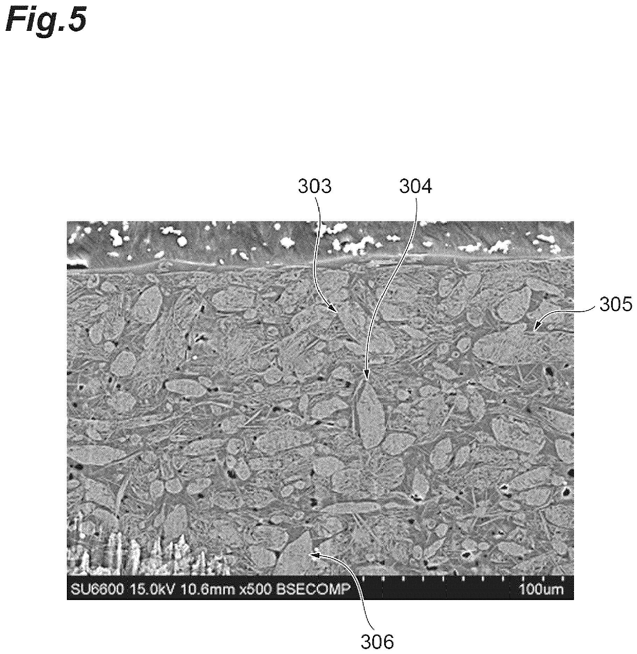

FIG. 4 is an SEM photograph showing an example of a cross-section of the boron nitride sintered body of the present embodiment. FIG. 5 is an SEM photograph showing a comparative example of a cross section of a boron nitride sintered body. The cross-sectional image of the boron nitride sintered body shown in FIG. 4 does not include a lump particle formed by aggregation of primary particles. The boron nitride sintered body of the image is directly composed of primary particles rather than lump particles. That is, the primary particles are sintered together to form a boron nitride sintered body. On the other hand, lump particles 303, 304, and 305 having a particle size of 30 $\mu$m or more are shown in the image of the cross section of the boron nitride sintered body shown in FIG. 5. Even in the case of a lump particle in which only a part is projected as in a lump particle 306 shown in FIG. 5, if the particle size is 30 $\mu$m or more by measuring the particle size in the projected part, the lump particle is counted as a lump particle having a particle size of 30 $\mu$m or more.

The orientation index of the boron nitride sintered body of the present embodiment may be 10 or less or 9 or less. Accordingly, anisotropy of thermal conductivity can be sufficiently reduced. The orientation index is an index for quantifying the degree of orientation of the boron nitride crystal. The orientation index can be calculated as a peak intensity ratio [I(002)/I(100)] of a (002) plane and a (100) plane of boron nitride measured by an X-ray diffraction apparatus.

The thermal conductivity of the boron nitride sintered body may be 26W/(m· K) or more, 30W/(m· K) or more, or 40W/(m· K) or more. By using the boron nitride sintered body having high thermal conductivity, it is possible to obtain a heat dissipation member having sufficiently excellent heat dissipation performance. The thermal conductivity (H) can be obtained by the following calculation expression (1).

$$H = A \times B \times C \ (1)$$

In the expression (1), H represents thermal conductivity (W/(m· K)), A represents thermal diffusivity (m$^2$/sec), B represents bulk density (kg/m$^3$), and C represents specific heat capacity (J/(kg· K)). The thermal diffusivity A can be measured by the laser flash method. The bulk density B can be measured from the volumes and masses of boron nitride sintered bodies. The specific heat capacity C can be measured using a differential scanning calorimeter.

The shape of the boron nitride sintered body is not particularly limited, and may be, for example, a sheet shape (thin plate shape) or a block shape. The boron nitride sintered body can be used as an insulating layer, a thermal interface material, or the like. The boron nitride sintered body contains boron nitride as a main component, and may contain an accessory component other than boron nitride. Examples of the accessory component include boron carbide, boron carbonitride, carbon, and calcium compounds. The boron nitride sintered body may have a boron nitride content of 90% by mass or more, 95% by mass or more, or 98% by mass or more. The content ratio of boron nitride can be measured by, for example, X-ray diffraction measurement.

The boron nitride sintered body obtained in this manner has sufficiently high thermal conductivity and is excellent in electrical insulating properties. Therefore, it can be suitably used as a heat dissipation member for various devices such as semiconductor devices. The boron nitride sintered body may contain pores. That is, the boron nitride sintered body may be porous. The boron nitride sintered body may comprise both closed pores and open pores. The porosity of the boron nitride sintered body may be 40 to 60% by volume, or may be 45 to 55% by volume. The porosity can be determined based on the theoretical density of boron nitride.

A composite body according to an embodiment includes the boron nitride sintered body described above and a resin filled in pores of the boron nitride sintered body. The above-described boron nitride sintered body is sufficiently densified and has sufficiently high thermal conductivity. Therefore, the composite body including the boron nitride sintered body also has high thermal conductivity. Such a composite body can be suitably used as a heat dissipation sheet. It is not necessary that all of the pores are filled with resin, and some of the pores may not be filled with resin. The composite body may include both closed pores and open pores. The resin may be a cured product of a thermosetting resin composition and/or a photocurable resin composition, or may be a semi-cured product.

The resin composition may contain, for example, at least one compound selected from the group consisting of a compound having a cyanate group, a compound having a bismaleimide group, and a compound having an epoxy group, and a curing agent.

Examples of the compound having a cyanate group include dimethylmethylene bis(1,4-phenylene)biscyanate, bis(4-cyanatephenyl)methane, and the like. Dimethylmethylene bis(1,4-phenylene)biscyanate is commercially available, for example, as, TACN (manufactured by MITSUBISHI GAS CHEMICAL COMPANY, INC., trade name).

Examples of the compound having a bismaleimide group include N,N'-[(1-methylethylidene)bis[[p-phenylene)oxy(p-phenylene)]]bismale imide, 4,4'-diphenylmethane bismaleimide, and the like. N,N'-[(1-methylethylidene)bis[[p-phenylene)oxy(p-phenylene)]]bismale imide is commercially available, for example, as BMI-80 (manufactured by K.I Chemical Industry Co., Ltd., trade name).

Examples of the compound having an epoxy group include a bisphenol F type epoxy resin, a bisphenol A type epoxy resin, a biphenyl type epoxy resin, a polyfunctional epoxy resin, and the like. For example, 1,6-bis(2,3-epoxypropan-1-yloxy)naphthalene or the like that is commercially available as HP-4032D (manufactured by DIC Corporation, trade name) may be exemplified.

The curing agent may include a phosphine-based curing agent and/or an imidazole-based curing agent. The phosphine-based curing agent may promote a triazine-generating reaction by trimerization of the compound having a cyanate group or a cyanate resin. Examples of the phosphine-based curing agent include tetraphenyl phosphonium tetra-p-tolyl borate, tetraphenyl phosphonium tetraphenyl borate, and the like. Tetraphenyl phosphonium tetra-p-tolyl borate is commercially available, for example, as TPP-MK (manufactured by HOKKO CHEMICAL INDUSTRY CO., LTD., trade name).

The imidazole-based curing agent generates oxazoline and promotes a curing reaction of the compound having an epoxy group or an epoxy resin. Examples of the imidazole-based curing agent include 1-(1-cyanomethyl)-2-ethyl-4-methyl-1H-imidazole, 2-ethyl-4-methylimidazole, and the like. 1-(1-Cyanomethyl)-2-ethyl-4-methyl-1H-imidazole is commercially available, for example, as 2E4MZ-CN (manufactured by SHIKOKU CHEMICALS CORPORATION, trade name).

The content of the phosphine-based curing agent may be, for example, 5 parts by mass or less, 4 parts by mass or less, or 3 parts by mass or less, with respect to 100 parts by mass of the total amount of the compound having a cyanate group, the compound having a bismaleimide group, and the compound having an epoxy group. The content of the phosphine-based curing agent may be, for example, 0.1 parts by mass or more or 0.5 parts by mass or more, with respect to 100 parts by mass of the total amount of the compound having a cyanate group, the compound having a bismaleimide group, and the compound having an epoxy group.

The content of the imidazole-based curing agent may be, for example, 0.1 parts by mass or less, 0.05 parts by mass or less, or 0.03 parts by mass or less, with respect to 100 parts by mass of the total amount of the compound having a cyanate group, the compound having a bismaleimide group, and the compound having an epoxy group. The content of the imidazole-based curing agent may be, for example, 0.001 parts by mass or more or 0.005 parts by mass or more, with respect to 100 parts by mass of the total amount of the compound having a cyanate group, the compound having a bismaleimide group, and the compound having an epoxy group.

The resin composition is not limited to those described above, and a resin composition that is impregnated into the boron nitride sintered body and cured or semi-cured can be appropriately used.

A method of manufacturing a boron carbonitride powder according to an embodiment includes a nitriding step of firing a raw material powder containing boron carbide in a nitrogen-containing atmosphere to obtain a fired product containing boron carbonitride, and a pulverizing step of pulverizing the fired product to obtain a boron carbonitride powder having a specific surface area of 12 m$^2$/g or more.

The powder containing boron carbide can be prepared, for example, by the following procedure. Boric acid and acetylene black are mixed, and then heated in an inert gas atmosphere at 1800 to 2400°C for 1 to 10 hours to obtain a lump containing boron carbide. This lump can be prepared by pulverizing, washing, impurity removal, and drying.

In the nitriding step, a powder containing boron carbide is fired in a nitrogen-containing atmosphere to obtain a fired product containing boron carbonitride ($B_4CN_4$). The firing temperature in the nitriding step may be 1800°C or more or 1900°C or more. The firing temperature may be 2400°C or lower or 2200°C or lower. The firing temperature may be, for example, 1800 to 2400°C.

The nitrogen partial pressure in the nitriding step may be 0.6 MPa or more or 0.7 MPa or more. The nitrogen partial pressure may be 1.0 MPa or less or may be 0.9 MPa or less. The nitrogen partial pressure may be, for example, 0.6 to 1.0 MPa. When the nitrogen partial pressure is too low, there is a tendency that nitriding of boron carbide does not proceed easily. On the other hand, if the pressure is too high, the production cost tends to increase. The pressure in the present disclosure is an absolute pressure.

The nitrogen gas concentration of the atmosphere containing nitrogen in the nitriding step may be 95% by volume or more or 99.9% by volume or more. The firing time in the nitriding step is not particularly limited as long as the nitriding of the boron carbide sufficiently proceeds, and may be, for example, 6 to 30 hours or 8 to 20 hours.

In the pulverizing step, the fired product containing boron carbonitride obtained in the nitriding step is pulverized to obtain a boron carbonitride powder. Grinding may be carried out using a pulverizer. Examples of the pulverizer include a roller mill, a jet mill, a hammer mill, a pin mill, a rotary mill, a vibration mill, a planetary mill, an attritor, a bead mill and a ball mill.

The specific surface area of the fired product containing boron carbonitride before pulverizing is, for example, less than 12 m$^2$/g. The fired product is pulverized to obtain a boron carbonitride powder having a specific surface area of 12 m$^2$/g or more. The boron carbonitride powder thus obtained contains the lump particles 10, 11, and 12 having no outer shell part, as shown in FIG. 1. These specific surface areas are measured by the BET method. The specific surface area of the boron carbonitride powder after pulverization may be 13 m$^2$/g or more, 14 m$^2$/g or more, or 15 m$^2$/g or more, from the viewpoint of promoting generation and densification of boron nitride in a firing step described later. In addition, from the viewpoint of sufficiently increasing thermal conductivity when the boron nitride sintered body is formed, the specific surface area of the boron carbonitride powder may be 80 m$^2$/g or less, 70 m$^2$/g or less, or 60 m$^2$/g or less. An example of the specific surface area of the boron carbonitride powder after pulverization may be 12 to 80 m$^2$/g.

The boron carbonitride powder thus refined is sufficiently densified by firing. Therefore, when the boron carbonitride powder obtained by the above-described manufacturing method is used for manufacturing a boron nitride sintered body, a boron nitride sintered body having sufficiently high thermal conductivity can be manufactured. The use of the boron carbonitride powder is not limited to the production of a boron nitride sintered body.

A method of manufacturing a boron nitride sintered body according to an embodiment includes a firing step of molding and heating the blend containing a boron carbonitride powder and a sintering aid to obtain a boron nitride sintered body, the boron carbonitride powder being manufactured by the manufacturing method including the nitriding step and the pulverizing step described above.

The sintering aid has a function of generating boron nitride from boron carbonitride and promoting densification of the boron nitride. The sintering aid may contain a boron compound having oxygen as a constituent element and a calcium compound. The blend may contain the boron compound and the calcium compound in a total amount of 1 to 50 parts by mass, 3 to 47 parts by mass, or 5 to 45 parts by mass relative to 100 parts by mass of the fired product. When the content of the sintering aid in the blend is excessive, the grain growth of the primary particles of boron nitride proceeds excessively, and the average pore diameter of the pores contained in the boron nitride sintered body tends to increase. On the other hand, when the content of the sintering aid in the blend is excessively small, the generation of boron nitride and the grain growth of primary particles are less likely to proceed, and the thermal conductivity of the boron nitride sintered body tends to decrease.

The blend may contain 0.5 to 70 atom% or may contain 1 to 69 atom% of calcium constituting the calcium compound with respect to 100 atom% of boron constituting the boron compound. By containing boron and calcium in such a ratio, the thermal conductivity of the boron nitride sintered body can be further increased by promoting homogeneous grain growth of primary particles.

Examples of the boron compound having oxygen as a constituent element include boric acid, boron oxide, borax, and diboron trioxide. Examples of the calcium compound include calcium carbonate and calcium oxide. The sintering aid may contain a component other than the boron compound and calcium carbonate. Examples of such a component include alkali metal carbonates such as lithium carbonate and sodium carbonate. In order to improve moldability, a binder may be added to the formulation. Examples of the binder include acrylic compounds and the like.

Blending of the fired product and the sintering aid may be performed using a mixer such as a Henschel mixer. Blending may be carried out using a pulverizer or crusher. The blend may be formed into a block-shaped or sheet-shaped molded body by powder pressing or molding, or may be formed into a sheet-shaped molded body by a doctor blade method. The molding pressure may be, for example, 5 to 350 MPa.

The molded body thus obtained is heated and fired in, for example, an electric furnace. The heating temperature may be, for example, 1800°C or higher or 1900°C or higher. The heating temperature may be, for example, 2200°C or lower, or 2100°C or lower. When the heating temperature is too low, there is a tendency that grain growth does not sufficiently proceed. The heating time may be 0.5 hours or more, or may be 1 hour or more, 3 hours or more, 5 hours or more, or 10 hours or more. The heating time may be 40 hours or less, 30 hours or less, or 20 hours or less. The heating time may be, for example, 0.5 to 40 hours, or may be 1 to 30 hours. If the heating time is too short, there is a tendency that grain growth does not sufficiently proceed. On the other hand, if the heating time is too long, the production cost tends to increase. The heating atmosphere may be, for example, an inert gas atmosphere such as nitrogen, helium, or argon. When a binder is added to the blend, the binder may be degreased by calcination at a temperature and in an atmosphere at which the binder is decomposed before the heating.

The method of manufacturing the boron nitride sintered body is not limited to the above-described embodiment. In another embodiment, in the pulverizing step, the fired product obtained in the nitriding step and the sintering aid may be blended and pulverized to obtain a powder composition containing boron carbonitride powder and the sintering aid having a specific surface area of 12 $m^2/g$ or more. That is, in the above-described embodiment, the fired product obtained by the nitriding step is pulverized and then the sintering aid is blended, but in this other embodiment, the fired product obtained by the nitriding step and the sintering aid are blended and then pulverized to obtain a powder composition containing the boron carbonitride powder and the sintering aid and having a specific surface area of 12 $m^2/g$ or more. The powder composition may be molded and heated to obtain the boron nitride sintered body. This makes it possible to simultaneously pulverize the fired product and blend the boron carbonitride powder and the sintering aid. The pulverization of the blend containing the fired product and the sintering aid can be performed using the pulverizer described in the above embodiment. The range of the specific surface area of the powder composition may be the same as that of the boron carbonitride powder of the above embodiment.

The method for manufacturing the boron nitride sintered body according to any of the above-described embodiments can manufacture the boron nitride sintered body having sufficiently high thermal conductivity. Thus, for example, a boron nitride sintered body having a cross-sectional structure as shown in FIG. 4 can be obtained. That is, it is possible to obtain a boron nitride sintered body in which an average number of lump particles having a particle size of 30 $\mu$m or more, which are formed by aggregation of primary particles of boron nitride, is 3 or less in a cross-sectional image including 100 or more particles, which is observed at a magnification of 500 times by SEM.

A method for manufacturing a composite body according to an embodiment includes an impregnating step of impregnating the boron nitride sintered body obtained by the above-described manufacturing method with a resin composition. The impregnating step is performed by attaching the resin composition to the boron nitride sintered body. For example, the boron nitride sintered body may be immersed in the resin composition. The immersion may be carried out under pressurized or depressurized conditions. In this way, the pores of the boron nitride sintered body can be filled with resin. As the resin composition, the thermosetting resin composition may be used.

The impregnating step may be carried out using an impregnation apparatus including a closed vessel. As an example, impregnation may be performed under a reduced pressure condition in the impregnation device, and then impregnation may be performed under a pressurized condition by increasing the pressure in the impregnation device to be higher than atmospheric pressure. The pores of the boron nitride sintered body can be sufficiently filled with the resin by performing both the pressure reducing condition and the pressure increasing condition. The reduced-pressure condition and the pressurized condition may be repeated a plurality of times. The impregnating step may be carried out while heating. The resin composition impregnated into the pores of the boron nitride sintered body becomes a resin (cured product or semi-cured product) after curing or semi-curing proceeds or the solvent is volatilized. In this way, a composite body having the boron nitride sintered body and the resin filled in the pores thereof is obtained.

After the impregnating step, a curing step of curing the resin filled in the pores may be included. In the curing step, for example, the composite body filled with the resin is taken out from the impregnation device, and the resin composition is cured or semi-cured by heating and/or light irradiation depending on the type of the resin composition (or a curing agent added as necessary).

The composite body thus obtained is sheet-like and has a small thickness. Therefore, it is thin and lightweight, and when used as a member of an electronic component or the like, the electronic component or the like can be reduced in size and weight. In addition, since the pores of the boron nitride sintered body are sufficiently filled with the resin, the insulating property is also excellent. However, the use thereof is not limited to the heat dissipation member.

Although several embodiments have been described above, the present disclosure is not limited to the above-described embodiments. For example, in the firing step, the boron nitride sintered body may be obtained by hot pressing in which molding and heating are simultaneously performed.

[Example]

The content of the present disclosure will be described in more detail with reference to Examples and Comparative Examples, but the present disclosure is not limited to the following Examples.

[Boron nitride sintered body]

(Example 1)

<Preparation of boron carbonitride powder>

100 parts by mass of orthoboric acid manufactured by Nippon Denko Co., Ltd. and 35 parts by mass of acetylene black (trade name: HS100) manufactured by Denka Company Limited were mixed using a Henschel mixer. The obtained mixture was filled in a graphite crucible and heated in an arc furnace in an argon gas atmosphere at 2200°C for 5 hours to obtain lump boron carbide ($B_4C$). The obtained lump product was coarsely pulverized with a jaw crusher to obtain a coarse powder. This coarse powder was further pulverized with a ball mill having silicon carbide beads ($\phi$10 mm) to obtain a pulverized powder. The carbon content of the obtained boron carbide powder was 19.9% by mass. The amount of carbon was measured by a carbon/sulfur simultaneous analyzer.

The prepared boron carbide powder was filled in a boron nitride crucible. Thereafter, the crucible was heated for 10 hours using a resistance heating furnace in a nitrogen gas atmosphere under the conditions of 2000°C and 0.85 MPa. The fired product was milled for 16 hours using a ball mill as a pulverizer.

<Measurement of specific surface area>

The specific surface areas of the boron carbonitride powder ($B_4CN_4$ powder) obtained by pulverization and the fired product before pulverization were measured by the BET single point method using a specific surface area measuring device (trade name: Macsorb HM Model 1200) manufactured by Mountech Co., Ltd. The measurement results were as shown in Table 1. Table 1 shows the specific surface area before pulverization and the specific surface area after pulverizing.

<Measurement of content of boron carbonitride>

The content of boron carbonitride in the boron carbonitride powder ($B_4CN_4$ powder) obtained by pulverization and the fired product before pulverization was calculated by the following calculation expression (2) from a measured value D [% by weight] of nitrogen content and the theoretical nitrogen content (50.4% by mass) in the boron carbonitride.

$$\text{Content of boron carbonitride (mass\%)} = D / 50.4 \times 100 \quad (2)$$

The measured value D of nitrogen content was measured using an oxygen-nitrogen analyzer (trade name: EMGA-920) manufactured by HORIBA, Ltd. The content of boron carbonitride according to the calculation expression (2) was 94% by mass without change before and after the pulverization.

<Observation by scanning electron microscope (SEM)>

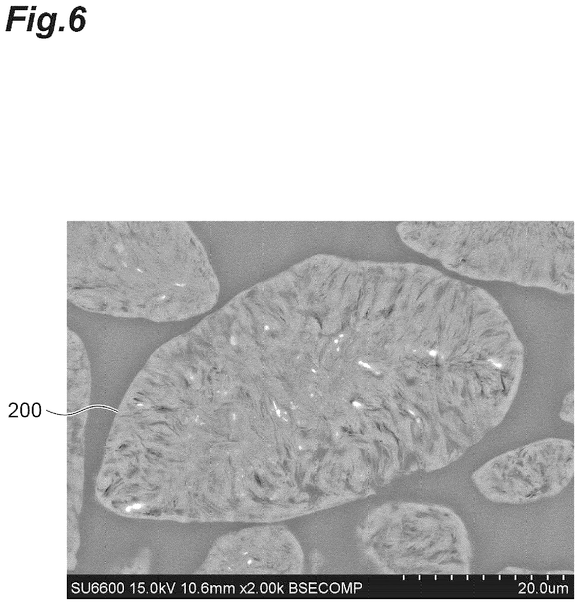

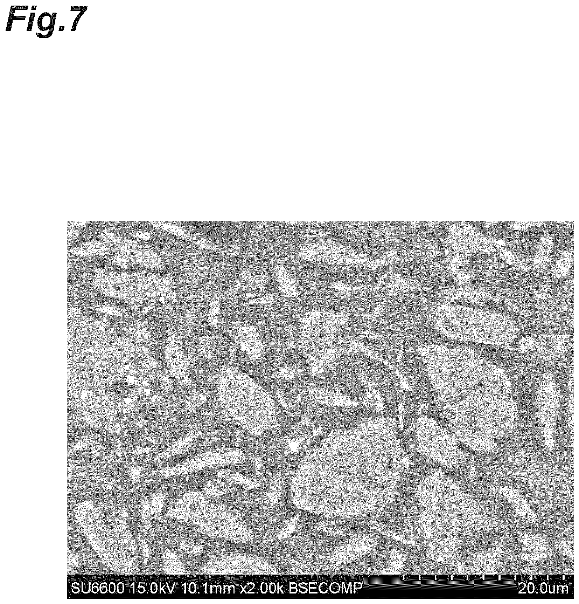

The fired product before pulverization and the boron carbonitride powder obtained by pulverization were cut using an ion milling apparatus to obtain a cross section. Using a scanning electron microscope (manufactured by Hitachi High-Tech Corporation, device name: SU6600), the cross sections of the fired product before pulverization and the boron carbonitride powder obtained by pulverization were each observed at a magnification of 500 times. FIG. 6 is an SEM photograph showing a cross section of the fired product before pulverization. FIG. 7 is an SEM photograph showing a cross section of the boron carbonitride powder. As shown in FIG. 6, it was confirmed that all particles of the fired product before pulverization had the outer shell part 200. On the other hand, in the boron carbonitride powder, it was confirmed that the outer shell part 200 disappeared as shown in FIG. 7. Cross-sectional images as shown in FIG. 7 were photographed in 20 different fields of view, and lump particles included in each SEM photograph were observed. As a result, it was confirmed that the outer shell part disappeared in any lump particle, and the primary particles were exposed at the outer edge of the lump particle.

<Production of boron nitride sintered body>

Powdery boric acid and calcium carbonate were blended to prepare a sintering aid. Upon the preparation, 1.9 parts by mass of calcium carbonate was blended with respect to 100 parts by mass of boric acid. Regarding the atomic ratio of boron and calcium at this time, the atomic ratio of calcium was 1.2 atom% with respect to 100 atom% of boron. 19 parts by mass of the sintering aid was blended with respect to 100 parts by mass of the boron carbonitride powder described above and mixed using a Henschel mixer to obtain a powdery blend.
The blend was pressurized using a powder pressing machine at 150 MPa for 30 seconds to obtain a molded body having a quadrangular prism-shaped (length × width × thickness = 50 mm × 50 mm × 50 mm). The molded body was put in a boron nitride container and introduced into a batch-type high-frequency furnace. In the batch-type high-frequency furnace, heating was performed for 5 hours under the conditions of normal pressure, a nitrogen flow rate of 5 L/min, and 2000°C. Thereafter, a boron nitride sintered body was extracted from the boron nitride container. In this way, a quadrangular prism-shaped boron nitride sintered body was obtained. The thickness of the boron nitride sintered body was 53 mm. This thickness was measured with a caliper.

<Measurement of thermal conductivity>

The thermal conductivity (H) in the thickness direction of the boron nitride sintered body was obtained by the above-described calculation expression (1). The thermal diffusivity A was measured by a laser flash method using a sample obtained by processing a boron nitride sintered body into a size of length × width × thickness = 10 mm × 10 mm × 0.40 mm. A xenon flash analyzer (manufactured by NETZSCH, trade name: LFA447NanoFlash) was used as a measurement device. The bulk density B was calculated from the volumes and masses of the boron nitride sintered bodies. The specific heat capacity C was measured using a differential scanning calorimeter. The thermal conductivity was as shown in Table 1.

<Measurement of pore ratio>

From the bulk density B and the theoretical density (2280 kg/m$^3$) of boron nitride, the porosity was obtained by the following expression (3). The porosity was as shown in Table 1.

$$\text{Porosity (\% by volume)} = [1 - (B / 2280)] \times 100 \qquad (3)$$

<Measurement of orientation index>

An orientation index [I(002)/I(100)] of the boron nitride sintered body was obtained using an X-ray diffractometer (manufactured by Rigaku Corporation, trade name: ULTIMA-IV). A measurement sample (boron nitride sintered body) set in a sample holder of an X-ray diffraction apparatus was irradiated with X-rays to perform baseline correction. Then, the peak intensity ratio between the (002) plane and the (100) plane of boron nitride was calculated. The calculated result was made to be the orientation index [I(002)/I(100)] Results were as shown in Table 1.

<Cross section observation by scanning electron microscope (SEM)>

The boron nitride sintered body was cut along the thickness direction using a CP polishing machine to obtain a cross section. The cross section was observed with a scanning electron microscope (manufactured by Hitachi High-Tech Corporation, device name: SU6600) at a magnification of 500 times. FIG. 4 is an SEM photograph showing a cross section of the boron nitride sintered body of Example 1. When the cross section of the boron nitride sintered body as shown in FIG. 4 was observed in five different fields of view, any lump particles having a particle size of 30 μm or more were not included. All fields included more than 100 particles. The column of "SEM observation" in Table 1 shows the average number of lump particles having a particle size of 30 μm or more included in the cross-sectional image.

(Example 2)

Boron carbonitride powder was prepared in the same manner as in Example 1 except that in "preparation of boron carbonitride powder", a vibration mill was used instead of the ball mill as a pulverizer for pulverizing the fired product containing boron carbonitride ($B_4CN_4$), and the pulverizing time was 12 hours. When SEM observation was performed in the same manner as in Example 1, it was confirmed that all particles of the fired product before pulverization had the outer shell part 200. On the other hand, in the boron carbonitride powder, it was confirmed that the outer shell part disappeared and the primary particles were exposed at the outer edge of the lump particle as in Example 1. Using this boron carbonitride powder, a boron nitride sintered body was produced in the same manner as in Example 1. In the same manner as in Example 1, the specific surface area of the fired product before and after pulverization was measured, and each measurement and SEM observation of the boron nitride sintered body were performed. Results were as shown in Table 1.

(Example 3)

A fired product containing boron carbonitride ($B_4CN_4$) was obtained in the same manner as in Example 1. The specific surface area of this fired product was as shown in the column of "before pulverization" in Table 1. To 100 parts by mass of this fired product, 19 parts by mass of the sintering aid used in Example 1 was blended, and the blend was pulverized for 12 hours using a vibration mill. In this way, a powder composition containing boron carbonitride ($B_4CN_4$) and the sintering aid was obtained. When the powder composition was observed by SEM, it was confirmed that the outer shell part disappeared in any lump particle, and the primary particles were exposed at the outer edge of the lump particle. The specific surface area of this powder composition was measured in the same manner as for the boron carbonitride powder after pulverization in Example 1. The measurement results were as shown in the column of "after pulverization" in Table 1.

Using the obtained powder composition, a molded body was produced by the same procedure as in Example 1, and the molded body was heated in a batch-type high-frequency furnace to obtain a boron nitride sintered body having a quadrangular prism shape. Each measurement and SEM observation of the boron nitride sintered body were performed in the same manner as in Example 1. Results were as shown in Table 1.

(Example 4)

A sintering aid was prepared by blending powdery boric acid and calcium carbonate. In the preparation, 63.7 parts by mass of calcium carbonate was blended with respect to 100 parts by mass of boric acid. To 100 parts by mass of a boron carbonitride powder prepared in the same manner as in Example 1, 34.6 parts by mass of the sintering aid was added and mixed using a Henschel mixer to obtain a powdery blend. A boron nitride sintered body was produced in the same manner as in Example 1 except that this blend was used. Each measurement and SEM observation of the boron carbonitride powder and the boron nitride sintered body were performed in the same manner as in Example 1. Results were as shown in Table 1.

(Comparative Example 1)

A fired product containing boron carbonitride ($B_4CN_4$) was prepared by the same procedure as in Example 1. When the specific surface area of the fired product was measured in the same manner as in Example 1, the measurement results were as shown in Table 1. The fired product was mixed with a sintering aid using a Henschel mixer without pulverizing to prepare a blend. Using this blend, a boron nitride sintered body was produced in the same manner as in Example 1. Each measurement and SEM observation of the boron nitride sintered body were performed in the same manner as in Example 1. The results of each measurement were as shown in Table 1. An SEM photograph of a cross section of the fired product was as shown in FIG. 2. An SEM photograph of a cross section of the boron nitride sintered body was shown in FIG. 5.

Table 1

| | Before pulverization | After pulverization | Boron nitride sintered body | | | |
|---|---|---|---|---|---|---|
| | Specific surface area [m²/g] | Specific surface area [m²/g] | Thermal conductivity [W/(m · K)] | Polosity [Volume %] | Orientation index | SEM observation [piece] |
| Example 1 | 11.5 | 12.7 | 35 | 51.8 | 7 | 0 |
| Example 2 | 11.5 | 58.9 | 42 | 50.4 | 8 | 0 |
| Example 3 | 11.5 | 73.5 | 44 | 49.6 | 7 | 0 |
| Example 4 | 11.5 | 12.7 | 40 | 46.1 | 8 | 0 |
| Comparative Example 1 | 11.5 | - | 25 | 57.3 | 14 | >3 |

As a result of cross-sectional observation of the boron nitride sintered body by SEM, in Examples 1 to 4, lump particles having a particle size of 30 $\mu$m or more were not present in any of five cross-sectional images including 100 or more particles. On the other hand, in Comparative Example 1, lump particles having a particle size of 30 $\mu$m or more were present in all of five cross-sectional images containing 100 or more particles. The number average of lump particles having a particle size of 30 $\mu$m or more per cross-sectional image was more than 3.

[Composite body]

<Preparation of composite body>

Each of the boron nitride sintered bodies of Examples 1 to 4 and Comparative Example 1 was immersed in a resin composition containing an epoxy resin (manufactured by Mitsubishi Chemical Corporation, trade name: Epikote 807) and a curing agent (manufactured by Nippon Synthetic Chemical Industry Co., Ltd., trade name: ACHMEX H-84B) in an impregnation device controlled at 0.03kPa to impregnate the resin composition into the boron nitride sintered body. After the impregnation, the resin composition was cured by heating at 150°C for 60 minutes under atmospheric pressure to obtain a composite body. This composite body had a thickness and thermal conductivity equivalent to those of the boron nitride sintered body. Therefore, it is useful as a heat dissipation member of an electronic component.

**Industrial Applicability**

According to the present disclosure, a boron nitride sintered body having sufficiently high thermal conductivity and a method for manufacturing the same are provided. In addition, according to the present disclosure, a boron carbonitride powder capable of manufacturing such a boron nitride sintered body and a method for manufacturing the same are provided. According to the present disclosure, there are provided a boron nitride sintered body and a composite body suitable as a member of an electronic component or the like, and a method for manufacturing the same. In addition, a heat dissipation member suitable as a member of an electronic component or the like is provided.

**Reference Signs List**

10, 11, 12, 13, 101, 102, 103: lump particle; 20: primary particle; 200: outer shell part; 301, 302, 303, 304, 305, 306: lump particle.

**Claims**

1. A boron carbonitride powder comprising a lump particle of boron carbonitride having micropores, wherein a specific surface area of the boron carbonitride powder is 12 m²/g or more.

2. The boron carbonitride powder according to claim 1, wherein primary particles of the boron carbonitride are exposed at an outer edge of the lump particle.

3. A powder composition comprising a lump particle of boron carbonitride having micropores and a sintering aid, wherein a specific surface area of the powder composition is 12 m$^2$/g or more.

4. A boron nitride sintered body comprising primary particles of boron nitride,
   wherein, in a cross-sectional image including 100 or more particles observed at a magnification of 500 times with a scanning electron microscope, an average number of lump particles having a particle size of 30 μm or more formed by aggregation of the primary particles is 3 or less.

5. The boron nitride sintered body according to claim 4, wherein an orientation index of the boron nitride sintered body is 10 or less.

6. The boron nitride sintered body according to claim 4 or 5, wherein thermal conductivity of the boron nitride sintered body is 26W/(m· K) or more.

7. A method for manufacturing a boron carbonitride powder, the method comprising:

   a nitriding step of firing a raw material powder containing boron carbide in a nitrogen-containing atmosphere to obtain a fired product containing boron carbonitride; and
   a pulverizing step of pulverizing the fired product to obtain a boron carbonitride powder having a specific surface area of 12 m$^2$/g or more.

8. A method for manufacturing a boron nitride sintered body, the method comprising:

   a nitriding step of firing a raw material powder containing boron carbide in a nitrogen-containing atmosphere to obtain a fired product containing boron carbonitride;
   a pulverizing step of pulverizing the fired product to obtain a boron carbonitride powder having a specific surface area of 12 m$^2$/g or more; and
   a firing step of molding and heating a blend containing the boron carbonitride powder and a sintering aid to obtain the boron nitride sintered body.

9. A method for manufacturing a boron nitride sintered body, the method comprising:

   a nitriding step of firing a raw material powder containing boron carbide in a nitrogen-containing atmosphere to obtain a fired product containing boron carbonitride;
   a pulverizing step of mixing and pulverizing the fired product and a sintering aid to obtain a powder composition containing a boron carbonitride powder and the sintering aid and having a specific surface area of 12 m$^2$/g or more; and
   a firing step of molding and heating the powder composition to obtain a boron nitride sintered body.

10. The method for manufacturing the boron nitride sintered body according to claim 8 or 9, wherein the pulverizing step is performed by using a pulverizer.

11. The method for manufacturing the boron nitride sintered body according to any one of claims 8 to 10, wherein the boron carbonitride powder contains lump particles of boron carbonitride having micropores, and wherein the primary particles of boron carbonitride are exposed at an outer edge of the lump particle.

12. A composite body comprising:

   the boron nitride sintered body according to any one of claims 4 to 6; and
   a resin filled in pores of the boron nitride sintered body.

13. A method for manufacturing a composite body, the method comprising an impregnating step of impregnating pores of the boron nitride sintered body obtained by the manufacturing method according to any one of claims 8 to 11 with a resin composition, the composite body having the boron nitride sintered body and a resin filled in at least some of the pores of the boron nitride sintered body.

# Fig.1

SU6600 15.0kV 10.1mm x2.00k BSECOMP          20.0um

# *Fig.2*

SU6600 15.0kV 10.3mm x2.00k BSECOMP                20.0um

# Fig.3

Fig.4

SU6600 15.0kV 9.8mm x500 BSECOMP      100um

# Fig.5

## Fig.6

# Fig.7

SU6600 15.0kV 10.1mm x2.00k BSECOMP          20.0um

**INTERNATIONAL SEARCH REPORT**

International application No.

**PCT/JP2021/035435**

### A. CLASSIFICATION OF SUBJECT MATTER

*C01B 21/082*(2006.01)i; *C01B 21/064*(2006.01)i; *C04B 35/583*(2006.01)i; *C04B 41/82*(2006.01)i
FI:    C01B21/082 K; C01B21/064 B; C04B35/583; C04B41/82 B

According to International Patent Classification (IPC) or to both national classification and IPC

### B. FIELDS SEARCHED

Minimum documentation searched (classification system followed by classification symbols)

C01B21/082; C01B21/064; C04B35/583; C04B41/82

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2007-031170 A (NATIONAL INSTITUTE FOR MATERIALS SCIENCE) 08 February 2007 (2007-02-08) claims 1-18, paragraphs [0021], [0027], [0048]-[0052] | 1-2 |
| A | | 3-13 |
| X | JP 2009-119423 A (ASAHI KASEI CORP) 04 June 2009 (2009-06-04) claims 1-6, paragraphs [0018]-[0042] | 1 |
| A | | 2-13 |
| A | JP 2013-053018 A (DENKI KAGAKU KOGYO KK) 21 March 2013 (2013-03-21) entire text, all drawings | 1-13 |
| A | WO 2020/158758 A1 (DENKA COMPANY LTD) 06 August 2020 (2020-08-06) entire text, all drawings | 1-13 |

☐ Further documents are listed in the continuation of Box C.        ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **16 November 2021** | **30 November 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

International application No.
**PCT/JP2021/035435**

| Patent document cited in search report | Publication date (day/month/year) | Patent family member(s) | Publication date (day/month/year) |
|---|---|---|---|
| JP 2007-031170 A | 08 February 2007 | (Family: none) | |
| JP 2009-119423 A | 04 June 2009 | (Family: none) | |
| JP 2013-053018 A | 21 March 2013 | (Family: none) | |
| WO 2020/158758 A1 | 06 August 2020 | CN 113329970 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014162697 A